# EUROPEAN PATENT APPLICATION

(11) **EP 4 794 508 A1**
(43) Date of publication of application: **19.08.2026**
(21) Application number: 25213252.7
(22) Date of filing: 04.11.2025
(51) Int. Cl.: H10P 90/00, H10P 50/24

(54) **METHOD OF FORMING SILICON ON INSULATOR SUBSTRATE**

(30) Priority: 18.02.2025 KR 20250020907
(71) Applicant: SK hynix Inc., Bubal-eub Icheon-si Gyeonggi-do 17336 (KR)
(72) Inventor: KIM, Il Do, 17336 Icheon-si, Gyeonggi-do (KR); PARK, Chang Jin, 17336 Icheon-si, Gyeonggi-do (KR); KIM, Seung Bum, 17336 Icheon-si, Gyeonggi-do (KR)
(74) Representative: Isarpatent

(57) **Abstract**

In a method of forming an SOI substrate, an etch stopper layer, a semiconductor layer, a buried insulation layer and a first bonding insulation layer may be sequentially formed on an upper surface of a donor wafer to form a donor wafer structure. A second bonding insulation layer may be formed on an upper surface of a carrier wafer to form a carrier wafer structure. The donor wafer structure may be bonded on the carrier wafer structure to form a bonding structure in which the first and second bonding insulation layers face each other. After the donor wafer is grinded, the remaining donor wafer is stripped. The etch stopper layer may be removed using a plasma cleaning gas including NF₃ to expose the semiconductor layer. A surface of the exposed semiconductor layer may be treated to have a uniform thickness.

## Description

### BACKGROUND

### 1. Technical Field

Embodiments of the present disclosure relate to a semiconductor manufacturing technology, and more particularly to a method of forming a silicon on insulator (SOI) substrate with a semiconductor layer having a uniform thickness.

### 2. Related Art

Semiconductor memory devices such as a dynamic random access memory (DRAM) device, are required to have high integration density while satisfying fast operating speed characteristics.

To improve an integration density of current DRAM devices, a technology utilizing a vertical channel transistor as a cell switching element may have been proposed. The vertical channel transistor needs to be formed on an SOI substrate with a semiconductor layer. In order to ensure uniform memory cell characteristics and have an effective isolation between adjacent vertical channel transistors, a uniform thickness of the semiconductor layer is required.

### SUMMARY

Embodiments of the present disclosure provide a method of forming an SOI substrate having a uniform semiconductor layer.

According to embodiments of the present disclosure, there may be provided a method of forming an SOI substrate. In the method of forming the SOI substrate, an etch stopper layer, a semiconductor layer, a buried insulation layer and a first bonding insulation layer may be formed sequentially on an upper surface of a donor wafer to form a donor wafer structure. A second bonding insulation layer may be formed on an upper surface of a carrier wafer to form a carrier wafer structure. The donor wafer structure may be bonded on the carrier wafer structure so that the first bonding insulation layer and the second bonding insulation layer face each other to form a bonding structure. After the donor wafer may be grinded, a remaining donor wafer may be stripped by a wet cleaning process. The etch stopper layer may be removed using a plasma cleaning gas containing an NF₃ to expose the semiconductor layer. The exposed semiconductor layer may be surface-treated to have a uniform thickness.

In embodiments of the present disclosure, the etch stopper layer may be removed using a plasma cleaning apparatus with a plasma process chamber. A recombination aid layer, which may selectively increase an etch rate of the etch stopper layer may be formed on an inner wall of the plasma process chamber.

In embodiments of the present disclosure, the recombination aid layer may include a material, such as Ni or AIN that generates an F₂ component by recombination reaction with the NF₃-containing plasma cleaning gas.

According to embodiments of the present disclosure, there may be provided a method of forming an SOI substrate. In the method of forming the SOI substrate, an etch stopper layer, a semiconductor layer containing Si, a buried insulation layer and a first bonding insulation layer may be sequentially stacked on an upper surface of a donor wafer to form a donor wafer structure. A second bonding insulation layer may be formed on an upper surface of a carrier wafer to form a carrier wafer structure. The donor wafer structure and the carrier wafer structure may be boned to each other to form a bonding structure in which the first bonding insulation layer and the second bonding insulation layer face each other. The back surface of the donor wafer may then be grinded. The grinded surface of the bonding structure may then be cleaned. The donor wafer remaining after the grinding process may be stripped by a spin cleaning process to expose the etch stopper layer. The exposed etch stopper layer may be removed in a plasma process chamber with a recombination aid layer using a NF₃-containing plasma cleaning gas to expose the semiconductor layer. The surface of the semiconductor layer may then be treated to have a uniform thickness.

According to embodiments of the present disclosure, in the fabrication of SOI substrate, the etch stopper layer may be removed using the NF₃-containing plasma cleaning gas in the plasma cleaning apparatus with the process chamber covered with the recombination aid layer. The NF₃-containing plasma cleaning gas may increase a generation ratio of the F₂ component, which increases the etch rate of the etch stopper layer by the recombination aid layer. Accordingly, the generation ratio of the F₂ component to the F component may be increased relative to a flow rate of the NF₃ gas to increase the etch rate of the etch stopper layer relative to the semiconductor layer. Therefore, the etch stopper layer may be selectively removed without loss of the semiconductor layer. As a result, the SOI substrate having the uniform semiconductor layer may be fabricated

Further, when the donor wafer for forming the SOI substrate of embodiments of the present disclosure, the donor wafer may be finely grinded so that a thickness of the residual donor wafer in an edge region may be thicker than a thickness of the residual donor wafer thickness in central region. Accordingly, in the stripping process of the residual donor wafer having a relatively high strip ratio in the center region, the residual donor wafer may be stripped in a uniform ratio.

Furthermore, after removing the etch stopper layer, the exposed semiconductor layer may be subjected to a wet cleaning process or a rapid thermal treatment process in a hydrogen gas atmosphere to uniformly treat the surface of the semiconductor layer.

### BRIEF DESCRIPTION OF THE DRAWINGS

The above and another aspects, features and advantages of the embodiments of the present disclosure will be more easily understood from the following detailed description taken in conjunction with the accompanying drawings, in which:
FIG. 1 is a flowchart illustrating a method of forming an SOI substrate in accordance with embodiments of the present disclosure;
FIGS. 2A to 2C are cross-sectional views of a bonding structure for each process to illustrate a method of forming the bonding structure of FIG. 1;
FIG. 3 is a flowchart illustrating a process for grinding a donor wafer of FIG. 1;
FIG. 4 is a plan view illustrating a wafer grinding apparatus in accordance with embodiments of the present disclosure;
FIGS. 5A to 5D are cross-sectional views of a bonding structure for each process to illustrate a method of grinding a donor wafer of a bonding structure in accordance with embodiments of the present disclosure;
FIG. 6 is a flowchart illustrating a method of stripping a residual donor wafer in accordance with embodiments of the present disclosure;
FIG. 7 is a cross-sectional view illustrating a bonding structure with a stripped residual donor wafer in accordance with embodiments of the present disclosure;
FIG. 8 is a cross-sectional view illustrating a plasma cleaning apparatus in accordance with embodiments of the present disclosure; and
FIG. 9 is a cross-sectional view illustrating a bonding structure with the removed etch stopper layer in accordance with embodiments of the present disclosure.

### DETAILED DESCRIPTION

The advantages and features of the embodiments of the present disclosure, and methods of achieving them, will become apparent upon reference to the embodiments described in detail with reference to the accompanying drawings. However, the invention is not limited to the embodiments disclosed herein, but may be embodied in many different forms. These embodiments are provided merely to make the present disclosure complete and to provide a complete picture of the scope of the present disclosure to one of ordinary skill in the art. The dimensions and relative sizes of the layers and regions in the drawings may be exaggerated for clarity of description. Throughout this specification, like reference numerals refer to like components.

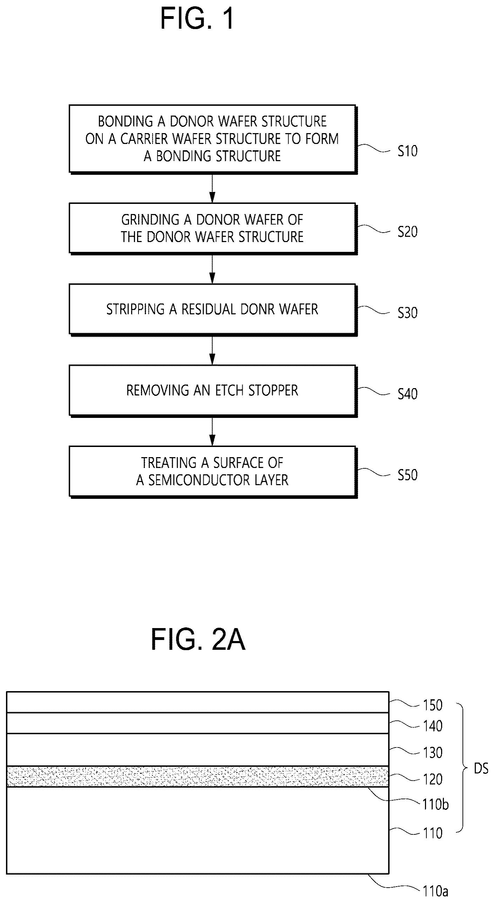

FIG. 1 is a flowchart illustrating a method of forming an SOI substrate in accordance with embodiments of the present disclosure, and FIGS. 2A to 2C are cross-sectional views of a bonding structure for each process to illustrate a process for forming a bonding structure in process S10 of FIG. 1.

Referring to FIG. 1, an SOI substrate may be formed in the following manner.

First, a donor wafer structure and a carrier wafer structure may be bonded to form a bonding structure (S10). For example, the donor wafer structure may include a donor wafer, an etch stopper layer, and a semiconductor layer.

Next, the donor wafer of the donor wafer structure may be grinded (S20).

After the grinding process (S20), the remaining donor wafer may be stripped (S30).

The etch stopper layer of the donor wafer structure may then be selectively removed (S40) to form an SOI substrate in which the semiconductor layer is exposed.

Subsequently, the exposed semiconductor layer of the SOI substrate may be surface-treated (S50) to improve a thickness distribution of the semiconductor layer.

The process S10 for forming the bonding structure will be described in detail with reference to FIGS. 2A to 2C.

Referring to FIG. 2A, a donor wafer structure DS may be prepared. The donor wafer structure DS may include a donor wafer 110. The donor wafer 110 may include a first surface 110a and a second surface 110b that face each other. The donor wafer 110 may be a sacrificial wafer to be subsequently removed. For example, the donor wafer 110 may include a silicon (Si) material. Further, the first surface 110a may correspond to an upper surface of the donor wafer 110. The second surface 110b may include a rear or bottom surface of the donor wafer 110.

An etch stopper layer 120 may be formed on the first surface 110a of the donor wafer 110. The etch stopper layer 120 may include a material having an etch selectivity with the donor wafer 110 and a semiconductor layer to be formed later, respectively. For example, the etch stopper layer 120 may be a single crystalline SiGe layer.

A semiconductor layer 130 may be formed on the etch stopper layer 120. In embodiments, the semiconductor layer 130 may be a region in which a channel of a transistor in a semiconductor memory device may be formed later. The semiconductor layer 130 may include, for example, a single crystalline Si material.

A buried insulation layer 140 and a first bonding insulation layer 150 may be sequentially stacked over the semiconductor layer 130 to form the donor wafer structure DS. The buried insulation layer 140 may include a silicon oxide material. The first bonding insulation layer 150 may include at least one of a silicon nitride layer (Si₃N₄), a silicon oxide layer (SiO₂) and a silicon carbonitride layer (SiCN).

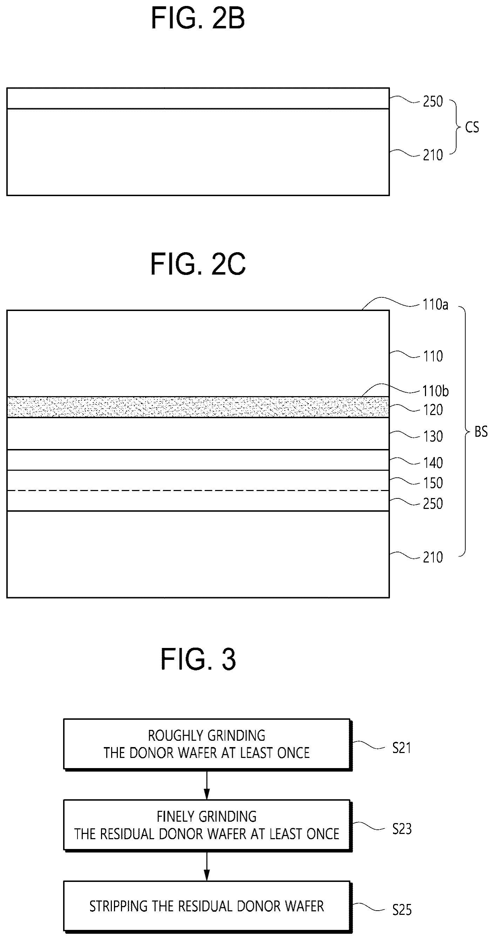

Referring to FIG. 2B, a carrier wafer structure CS may include a carrier wafer 210 and a second bonding insulation layer 250 formed over the carrier wafer 210. The carrier wafer 210 may include the same material as the donor wafer 110. The second bonding insulation layer 250 may include the same material as the first bonding insulation layer 150.

Referring to FIG. 2C, the donor wafer structure DS may be stacked on the carrier wafer structure CS so that the first bonding insulation layer 150 of the donor wafer structure DS and the second bonding insulation layer 250 of the carrier wafer structure CS may face each other. The first bonding insulation layer 150 and the second bonding insulation layer 250 may then be bonded by a hybrid bonding process to form a bonding structure BS. By forming the bonding structure BS in this manner, the second surface 110b of the donor wafer 110 may be facing upward.

FIG. 3 is a flowchart illustrating a process for grinding a donor wafer in process S20 of FIG. 1.

Referring to FIG. 3, in the process for grinding the donor wafer in process S20, the second surface 110b of the donor wafer 110 exposed to the bonding structure BS at least once may be roughly grinded (S21). For example, the donor wafer 110 may be roughly grinded to about 90% to about 96% of a total thickness of the donor wafer 110. The rough grinding process may include, for example, at least one high-speed rough grinding process and at least one low-speed rough grinding process. A greater amount of donor wafer 110 may be removed through the high-speed rough grinding process than through the low-speed rough grinding process.

After the rough grinding process (S21), the donor wafer 110 may be finely grinded at least once (S23). In embodiments, the finely grinding process (S23) may include a first low speed finely grinding process and a second low speed finely grinding process. A thickness of a residual donor wafer may be adjusted regionally by a final finely grinding process, for example, the second low speed finely grinding process. In this case, the residual donor wafer may be reduced to about 15µm to about 20µm by the finely grinding process.

After the finely grinding process (S23), the residual donor wafer of the bonding structure BS may be stripped (S25).

The process for grinding the donor wafer 110 of the bonding structure BS may be performed in a wafer grinding apparatus.

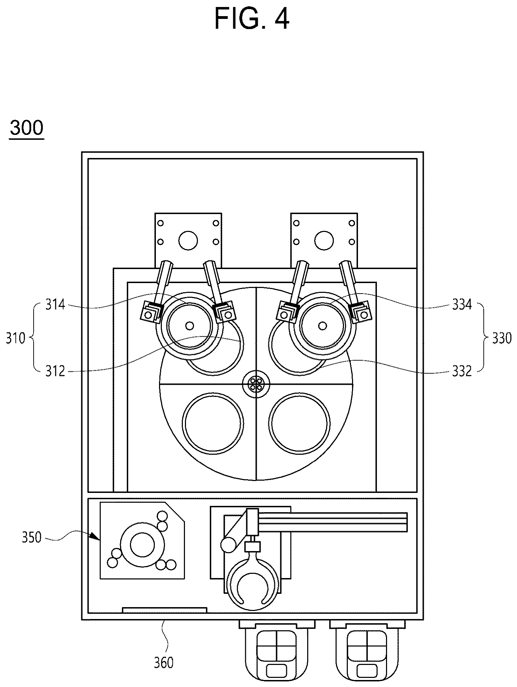

FIG. 4 is a plan view illustrating a wafer grinding apparatus 300 in accordance with embodiments of the present disclosure.

Referring to FIG. 4, the wafer grinding apparatus 300 may include a first grinding block 310, a second grinding block 330 and a cleaning block 350.

The first grinding block 310 may include a first support 312 and a first wheel 314. The first support 312 may support an object to be a grinded wafer. The first support 312 may rotate and elevate the wafer. The first wheel 314 may be positioned over the first support 312 to roughly grind the wafer positioned on the first support 312.

The second grinding block 330 may include a second support 332 and a second wheel 334. The second support 332 may also perform rotational and lifting movements. Further, a wafer receiving surface of the second support 332 may be configured to have a partially inclined structure. By the wafer receiving surface having the inclined structure, the wafer on the upper surface of the second support 332 may be grinded to have an inclined shape or a thickness difference in different regions. For example, the second support 332 may be configured to have a "V" shaped groove.

The second wheel 334 may be positioned over the second support 332. A size of the second wheel 334 may be smaller than a size of the first wheel 314. Accordingly, the second grinding block 330 may be able to grind a grinding thickness of the wafer more finely than the first grinding block 310.

The cleaning block 350 may strip the residual donor wafer of the bonding structure BS on which the grinding process has been performed. The cleaning block 350 may perform a wet cleaning treatment and a drying process of the bonding structure BS. For example, the cleaning block 350 may be located between the first and second grinding blocks 310 and330 and an unloading region 360.

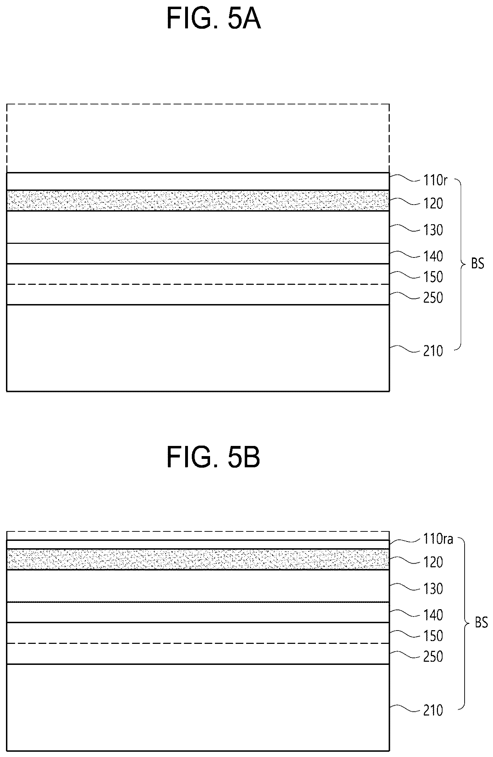

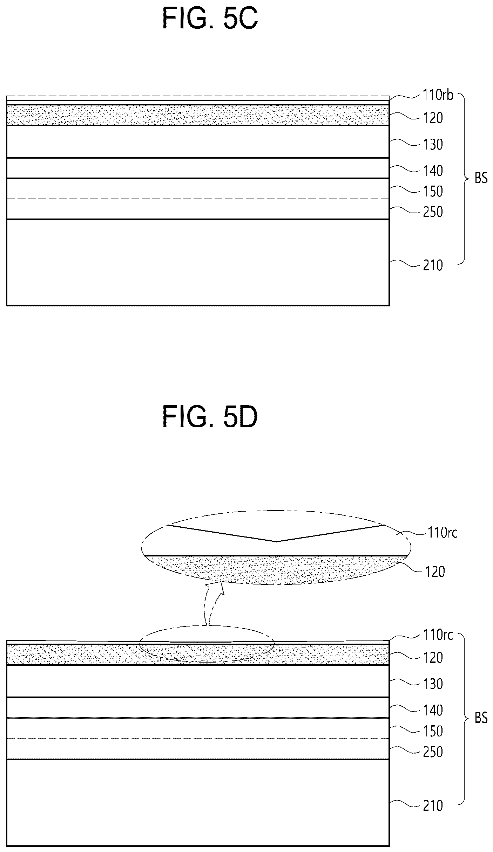

FIGS. 5A to 5D are cross-sectional views of a bonding structure for each process to illustrate a method of grinding a donor wafer of a bonding structure in accordance with embodiments of the present disclosure.

Referring to FIGS. 3, 4 and 5A, the rough grinding process (S21) of the bonding structure BS may be performed by the first grinding block 310 having the first wheel 314 of relatively large size.

As described above, the rough grinding process (S21) may include the high-speed rough grinding process and the low-speed rough grinding process. A large portion of the donor wafer 110 may be removed quickly through the high-speed rough grinding process.

In embodiments, when an overall thickness of the donor wafer 110 may be about 775µm, the donor wafer 110 may be high-speed rough-grinded to a thickness of about 715µm to about 720 µm at a speed of about 7 µm/sec to about 9 µm/sec. A reference numeral 110r in FIG. 5A may indicate a donor wafer remaining after the high-speed rough grinding process (hereinafter, referred to as a residual donor wafer).

Thereafter, referring to FIGS. 3, 4 and 5B, the residual donor wafer 110r may be subjected to the low-speed rough grinding process. For example, a low-speed rough grinding speed may be from about 2 µm/sec to about 4 um/sec. By the low-speed rough grinding process, about 2% to about 3% of the total thickness of the donor wafer 110 may be grinded, for example, about 15.5 µm to about 23.25 µm. A reference numeral 110ra in FIG. 5B may indicate a residual donor wafer after the low speed rough grinding process.

Next, as shown in FIGS. 3, 4 and 5C, the residual donor wafer 110ra after the rough grinding process may be subjected to the finely grinding process (S23). In embodiments, the finely grinding process (S23) may be performed on the second grinding block 330 including the second wheel 334 of relatively small size.

In embodiments, the finely grinding process (S23) may include a first low-speed precision grinding process and a second low-speed precision grinding process.

The residual donor wafer 110ra, see FIG. 5B, may be grinded at a rate of about 0.7 to about 0.9 µm/sec such that a portion of the thickness of the residual donor wafer 110ra, for example, about 14 µm to 16 µm, may be grinded at a rate of about 0.7 to about 0.9 µm/sec by the first low speed finely grinding process.

Next, referring to FIGS. 3, 4 and 5D, the residual donor wafer 110rb (see FIG. 5C) on which the first low-speed finely grinding process has been performed may be grinded down by the second low-speed finely grinding process at a speed of about 0.4 to about 0.6 µm/sec such that a portion of the thickness of the residual donor wafer 110rb, for example, by about 4 µ*m* to about 6 µm, may be grinded down at a speed of about 0.4 to about 0.6 µm /sec. After the precision grinding process is completed, a residual donor wafer 110rc having a thickness of 15 µm to 20 µm may be left on the bonding structure BS.

In embodiments, through the second low-speed precision grinding process corresponding to the final finely grinding process, the thickness of the residual donor wafer 110rc may be controlled by regions.

As described above, as the wafer receiving surface of the second support 332 may be configured to be inclined, the final residual donor wafer 110rc may be grinded so that the thickness of the central region of the final residual donor wafer 110rc may be thicker than the thickness of the edge region of the final residual donor wafer 110rb, see FIG. 5C. Further, the thickness of the final residual donor wafer 110rc may be adjusted by changing the inclination of the wafer receiving surface of the second support 332 during the second low-speed finely grinding process.

At this time, the difference between the thickness of the central region of the residual donor wafer 110rc and the thickness of the edge region of the residual donor wafer 110rc may be maintained at about 1 µm to 2 µm.

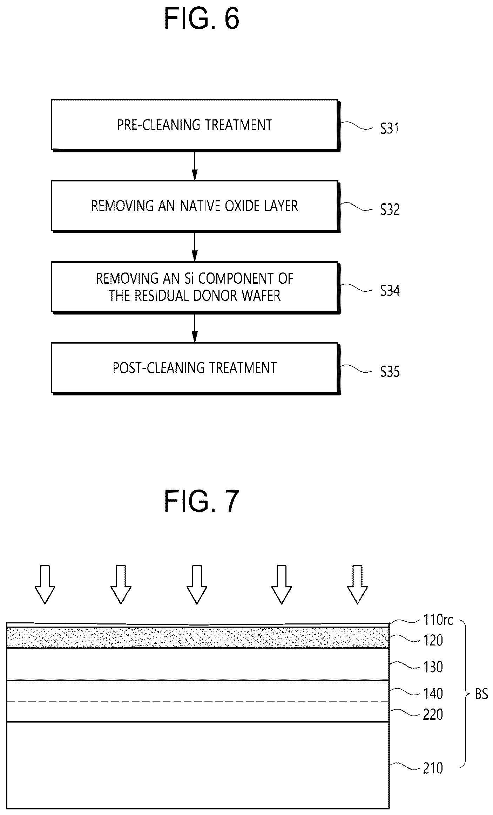

FIG. 6 is a flowchart illustrating a process for stripping a residual donor wafer in accordance with embodiments of the present disclosure, and FIG. 7 is a cross-sectional view illustrating a bonding structure with stripped residual donor wafers in accordance with embodiments of the present disclosure.

Referring to FIGS. 1, 4, 6 and 7, the bonding structure BS on which the finely grinding process S23 has been performed may be transported to the cleaning block 350.

The residual donor wafer 110rc of the bonding structure BS may be stripped (S30) in the cleaning block 350. For example, the process for stripping the residual donor wafer 110rc (S30) may include a process of removing a native oxide layer (S32) and a process of removing a silicon (Si) component of the residual donor wafer 110rc (S34).

The native oxide layer (not shown) may be caused by a reaction of the residual donor wafer 110rc with air during the grinding process of the bonding structure BS or during the transfer of the bonding structure BS. Since the native oxide layer may be formed to cover the surface of the residual donor wafer 110rc, the removal of the native oxide layer may be preceded by the removal of the residual donor wafer 110rc. For example, the native oxide layer may be removed using a about 1:100 diluted HF (diluted HF) solution.

Optionally, prior to the removal of the native oxide layer, the bonding structure BS may be further subjected to a pre-cleaning treatment (S31). The pre-cleaning treatment (S31) may be a process for removing process particles and metal byproducts generated by the rough and finely grinding processes (S21 and S23). The pre-cleaning treatment (S31) may include, for example, processes of spraying a chemical containing ozone (O₃) to the bonding structure BS for about 20 to about 30 seconds, dipping the bonding structure BS in deionized water, and drying the bonding structure BS.

After removing the native oxide layer, the Si component of the residual donor wafer 110rc may be stripped (S34). The Si component of the residual donor wafer 110rc may be wet-stripped using an NH₄OH solution. In the wet stripping of the residual donor wafer 110rc, in order to increase an etch selectivity of the Si component with the SiGe component included in the etch stopper layer 120, the NH₄OH solution may be used in which NH₄OH and H₂O may be diluted in a ratio of about 1 to about 20~40. Since the diluted NH₄OH solution may have a higher OH group content than the NH₄OH undiluted solution, reactivity of the diluted NH₄OH solution with the Si component included in the residual donor wafer 110rc may be improved. Further, the wet strip process S34 of the Si component may be carried out at a temperature of about 25 to about 70°C.

After stripping the Si component (S34), the bonding structure BS may be subjected to a post-cleaning treatment (S35). For example, the post-cleaning treatment (S35) may include rinsing the bonding structure using H₂O, and drying the bonding structure using isopropyl alcohol (IPA).

The cleaning block 350 may include a spin chuck (not shown) rotationally driven at a constant speed. The bonding structure BS may be placed on the spin chuck. The bonding structure BS may then be spin-cleaned by a chemical solution that is sprayed while rotating.

However, when the residual donor wafer 110rc may be stripped by the spin cleaning process, the edge region of the residual donor wafer 110rc may be stripped faster than the central region of the residual donor wafer 110rc, resulting in a decrease in strip uniformity. In order to improve the strip uniformity of the spin cleaning process, a relatively thick thickness may be provided to the edge region of the residual donor wafer 110rc at the finely grinding process (S23). Accordingly, upon cleaning of the bonding structure (BS) by the dilute NH₄OH solution, a strip ratio may be maintained uniformly in each region of the residual donor wafer 110rc.

Again, referring to FIG. 1, the process S40 for removing the etch stopper layer may be performed in a plasma cleaning device.

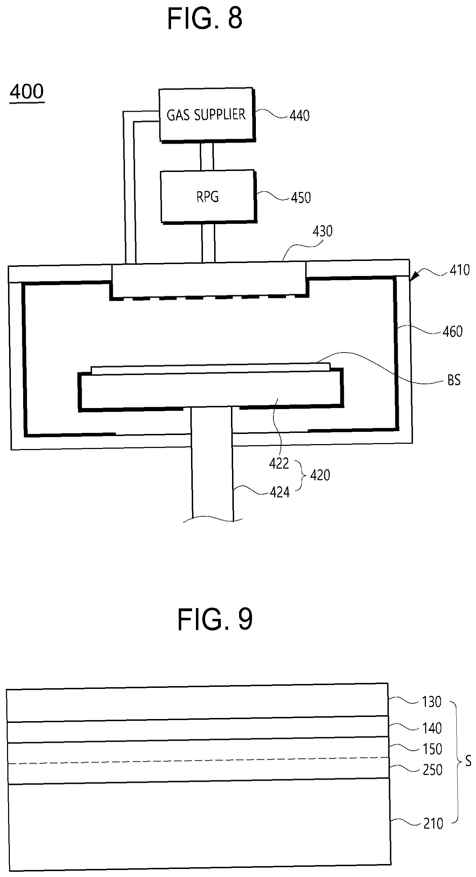

FIG. 8 is a cross-sectional view illustrating a plasma cleaning apparatus 400 in accordance with embodiments of the present disclosure, and FIG. 9 is a cross-sectional view illustrating a bonding structure BS with the etch stopper layer removed in accordance with embodiments of the present disclosure.

Referring to FIG. 8, the plasma cleaning apparatus 400 may include a process chamber 410, a substrate support 420, a gas injector 430, a gas supplier 440 and a remote plasma generator (RPG) 450.

The process chamber 410 may provide space for a cleaning treatment of the bonding structure BS. In the process chamber 410, a cleaning treatment or an etching treatment using plasma may be performed. In embodiments, the stripping of the object by the cleaning medium may be understood as "etching"

The substrate support 420 may be positioned in the process chamber 410. The substrate support 420 may include a substrate receiving plate 422 and a support shaft 424. The bonding structure BS may be loaded on the substrate receiving plate 422. The substrate receiving plate 422 may be referred to as, for example, a pedestal or an electrostatic chuck. The substrate receiving plate 422 may include a temperature controller (not shown) such as a heater. The support shaft 424 may be perpendicularly coupled to a rear surface of the substrate receiving plate 422. The support shaft 424 may lift or rotate the substrate receiving plate 422

The gas injector 430 may be located in the process chamber 410. The gas injector 430 may be positioned in an upper region of the process chamber 410 opposite to the substrate receiving plate 422. The gas injector 430 may have a form of a showerhead, for example.

The gas supplier 440 may provide a plasma cleaning gas to the gas injector 430. The plasma cleaning gas may provide at least one source gas and at least one carrier gas. The gas supplier 440 may include at least one source gas supplier and at least one carrier gas supplier.

The remote plasma generator 450 may be connected between the process chamber 410 and the gas injector 430. The remote plasma generator 450 may receive the at least one plasma cleaning gas from the gas injector 430. The remote plasma generator 450 may generate the plasma cleaning gas in a plasma state. The remote plasma generator 450 may provide the plasma cleaning gas to the gas injector 430. In some cases, the carrier gas may be provided directly to the gas injector 430.

For example, when the etch stopper layer 120 may include SiGe material, the source gas may include a fluorine-containing gas, such as NF₃ gas. Further, the carrier gas may include Ar and He.

In order to selectively remove only the etch stopper layer 120, without loss of the semiconductor layer 130, the NF₃:Ar:He may be mixed in a ratio of about 1:100~400:150~600. For example, the source gas, NF₃ gas, may be supplied in an amount of 10 to 20sccm, the carrier gas, Ar gas, may be supplied in an amount of 1800 to 2000sccm, and the He gas may be supplied in an amount of 2900 to 4100sccm.

Since the amount of etching of the etch stopper layer 120 as well as the amount of etching of the semiconductor layer 130 containing Si material may be simultaneously increased as a flow rate of the NF₃ gas may be increased, the supply amount of the NF₃ gas may be supplied to satisfy a mixing ratio range of the plasma cleaning gas.

Further, to improve the etch selectivity of the etch stopper layer 120 containing SiGe material, the substrate support 420 may be maintained at a temperature of about 30 to 35°C. For example, when the temperature of the substrate support 420 may be increased above about 35°C, a reaction of the semiconductor layer 130 with fluorine atomic radicals F included in the plasma cleaning gas may be activated. As such, when the reaction of the fluorine atomic radicals F with the semiconductor layer 130 may be activated, damage may be generated to the surface of the semiconductor layer 130. Thus, it may be preferable to keep the temperature of the substrate support 420 below about 35°C.

Furthermore, an inner surface of the process chamber 410 may be further coated with a recombination aid layer 460. The recombination aid layer 460 may recombine with some components of the plasma cleaning gas to generate F₂ for removing the SiGe material included in the etch stopper layer 120.

In embodiments, when the NF₃ gas may be decomposed by plasma generated by the remote plasma generator 450, ions such as NF₂*, NF⁺ , N⁺ , F⁺ , F⁻, NF₃⁺; radical species such as NF₂, NF, N, and F; and neutral molecules such as N₂ and F₂; radicals, such as NF₂, NF, N, and F; and neutral molecules, such as N₂ and F₂, may be generated to produce the plasma cleaning gas.

Among the various components of the plasma cleaning gas, it is known that the F₂ component may have a high etch rate on the SiGe material included in the etch stopper layer 120, and the F component may have a high etch rate on the Si material included in the semiconductor layer 130. Accordingly, in order to selectively remove the etch stopper layer 120, the F₂/F ratio in the plasma cleaning gas may be increased. Increasing the flow rate of the NF₃ gas does not increase the F₂/F ratio, since the F component as well as the F2 component may be simultaneously increased. The F₂ component may be a neutral molecule, which may be generated by a recombination reaction under a plasma atmosphere. Accordingly, in embodiments, the recombination aid layer 460 may be formed on the inner wall of the process chamber 410 to selectively increase the generation rate of the F2 component for a set NF₃ gas flow rate. For example, the recombination aid layer 460 may be formed on the inner wall of the process chamber 410, on a surface of the substrate support, and on at least one of the gas injector 430, respectively. For example, the recombination aid layer 460 may include at least one of a Ni layer and an AIN layer. Further, the recombination aid layer 460 may be formed, for example, by a plating process.

As the etch stopper layer 120 may be optionally removed. As shown in FIG. 9, the semiconductor layer 130 of the donor wafer structure DS may be transcribed into the carrier wafer structure CS, thereby forming an SOI substrate S.

At this time, the semiconductor layer 130 on which semiconductor devices may be to be formed on the SOI substrate S may be formed by an epitaxial growth process using the etch stopper layer 120. Accordingly, by the selective removal of the etch stopper layer 120, the upper surface of the semiconductor layer 130 may have different thicknesses in different regions due to silicon aggregation and dangling bonds remaining. As such, the thickness of the semiconductor layer 130 of the SOI substrate S may be required to be consistent, as the thickness difference of the semiconductor layer 130 may cause performance differences of the transistors to be formed on the SOI substrate S thereafter.

To secure the thickness uniformity of the semiconductor layer 130, in embodiments, a surface treatment (S50) of the semiconductor layer 130 may be performed.

In embodiments, the surface treatment (S50) of the semiconductor layer 130 may include a wet cleaning process. The wet cleaning process may include spraying an SC-1 solution onto the surface of the semiconductor layer 130, and spraying a DHF solution onto the surface of the semiconductor layer 130.

The SC-1 solution may include NH₄OH, H₂O₂, and H₂O. A ratio of NH₄OH: H₂O₂: H₂O in the SC-1 solution may be from 1:1~4:10~20. The SC-1 solution may be maintained at a temperature of, for example, about 50°C to 80 °C. Since the SC-1 solution may contain a large amount of OH groups, Si aggregates or dangling bonds protruding from the surface of the semiconductor layer 130 may improve the roughness characteristics of the semiconductor layer 130.

Further, the DHF solution may remove any native oxide layer or oxidized particles remaining on the surface of the semiconductor layer 130.

In another embodiment, the surface treatment (S50) of the semiconductor layer 130 may include a process of rapid thermal treatment in a hydrogen gas (H₂) atmosphere. By the process of rapid thermal treatment in the hydrogen gas atmosphere, the dangling bonds, which may be generated on the surface of the semiconductor layer 130, may be removed. Further, the native oxide layer, which may be generated on the surface of the semiconductor layer 130 may be removed. Furthermore, the atomic structure of the surface of the semiconductor layer 130 may be rearranged, and the silicon atoms of the semiconductor layer 130 may be migrated, thereby improving the surface roughness characteristics of the semiconductor layer 130.

For example, the rapid thermal treatment process in the hydrogen gas atmosphere may be performed by supplying about 5 to 10slm of H2 gas at a temperature of about 600 to 900°C and a pressure of about 0.5 to 150torr for about 20 to 60 seconds. For example, when the rapid thermal treatment temperature is about 600 to 800 °C, the rapid thermal treatment process may be performed for about 40 to 60 seconds. When the rapid thermal treatment temperature is about 800 to 900°C, the rapid thermal treatment process may be performed for about 20 to 30 seconds.

The method may further include a process of hydrogen baking the surface of the semiconductor layer 130 in a temperature range from about 550 to 600°C prior to the rapid thermal treatment process in the hydrogen gas atmosphere. The hydrogen bake treatment may be performed at a relatively lower temperature than the rapid thermal treatment process, to prevent carbon C components included in the bonding insulation layer 150 and 350 from crowding into the semiconductor layer 130 due to a sudden increase in temperature.

According to embodiments, in forming the SOI substrate, the etch stopper layer may be removed using a NF₃-containing plasma cleaning gas in the plasma cleaning apparatus including the process chamber covered with the recombination aid layer. The NF₃-containing plasma cleaning gas may increase the rate of occurrence of the F₂ component, which increases the etch rate of the etch stopper layer by the recombination aid layer. Accordingly, the generation ratio of the F₂ component to the F component may be increased relative to the flow rate of the NF₃ gas, and the etch rate of the etch stopper layer relative to the semiconductor layer may be increased. Therefore, the etch stopper layer may be selectively removed without the loss of the semiconductor layer. As a result, the SOI substrate having the uniform semiconductor layer may be fabricated.

Furthermore, when fabricating the donor wafer for the SOI substrate in accordance with embodiments of the present disclosure, the donor wafer may be finely grinded so that the residual donor wafer thickness in the edge region may be thicker than the residual donor wafer thickness in the central region. Accordingly, in the stripping process of the residual donor wafer having the relatively high strip ratio in the central region, the residual donor wafer may be stripped in the uniform ratio.

Further, after removing the etch stopper layer, the exposed semiconductor layer may be subjected to the wet cleaning process or the rapid thermal treatment process in the hydrogen gas atmosphere to uniformly treat the surface of the semiconductor layer.

While the embodiments of the present disclosure have been described in detail with reference to specific embodiments, the invention is not limited to the above embodiments, but is capable of many modifications by those having ordinary skill in the art within the scope of the technical ideas of the present disclosure. Furthermore, the embodiments may be combined to form additional embodiments.

## Claims

1. A method of forming a silicon on insulator (SOI) substrate, the method comprising:
sequentially forming an etch stopper layer, a semiconductor layer, a buried insulation layer and a first bonding insulation layer on an upper surface of a donor wafer to form a donor wafer structure;
forming a second bonding insulation layer on an upper surface of a carrier wafer to form a carrier wafer structure;
bonding the donor wafer structure on the carrier wafer structure to form a bonding structure in which the first bonding insulation layer and the second bonding insulation layer face each other;
grinding a back surface of the donor wafer;
stripping the donor wafer remaining after the grinding;
removing the etch stopper layer using a plasma cleaning gas including NF₃to expose the semiconductor layer; and
surface-treating the semiconductor layer.

2. The method of claim 1,
wherein the etch stopper layer is removed in a plasma cleaning apparatus with a plasma process chamber, and
wherein an inner wall of the plasma process chamber is coated with a recombination aid layer configured to selectively increase an etch rate of the etch stopper layer.

3. The method of claim 2, wherein the recombination aid layer comprises a material for generating an F₂ component by a recombination reaction with the plasma cleaning gas including NF₃.

4. The method of claim 3, wherein the recombination aid layer comprises at least one of Ni and AIN.

5. The method of claim 1,
wherein the NF₃-containing plasma cleaning gas has a temperature of 30°C to 35°C, and
wherein the NF₃-containing plasma cleaning gas comprises NF₃ gas: Ar gas: He gas mixed in a ratio of 1:100~400:150~600.

6. The method of claim 1, wherein grinding the back surface of the donor wafer comprises:
rough grinding 90% to 96% of a total thickness of the donor wafer at least once; and
finely grinding the donor wafer at least once to form a residual donor wafer with a thickness of 15µm to 20µm.

7. The method of claim 6,
wherein finely grinding the donor wafer comprises positioning the bonding structure at an inclination, and
wherein an edge region of the residual donor wafer is left thicker than a central region of the residual donor wafer after the grinding.

8. The method of claim 7, wherein stripping the residual donor wafer comprises spraying a wet cleaning solution while rotating the bonding structure.

9. The method of claim 7, wherein stripping the residual donor wafer comprises:
treating a surface of the residual donor wafer with a 1:100 diluted HF solution (HF:H₂O=1:100) to remove a native oxide layer on a surface of the bonding structure;
removing the residual donor wafer using a diluted NH₄OH solution (NH₄OH:H₂O = 1:20 to 40);
rinsing the surface of the bonding structure from which the etch stopper layer is removed with H₂O; and
drying the surface of the bonding structure.

10. The method of claim 1, wherein surface-treating the semiconductor layer comprises spraying an SC-1 solution (NH₄OH:H₂O₂:H₂O = 1:1 to 4:10 to 20) at a temperature of 50°C to 80°C.

11. The method of claim 1, wherein surface-treating the semiconductor layer comprises performing a rapid thermal treatment by supplying 5 to 10slm of an H₂ gas to the semiconductor layer for 20 to 60 seconds at a temperature of 600 to 900°C under a pressure of 0.5 to 150torr to.

12. The method of claim 11, further comprising, prior to performing the rapid thermal treatment, hydrogen-baking the semiconductor layer at a temperature in a range of 550 to 600°C

13. A method of forming an SOI substrate, the method comprising:
sequentially stacking an etch stopper layer containing SiGe, a semiconductor layer containing Si, a buried insulation layer and a first bonding insulation layer on an upper surface of a donor wafer to form a donor wafer structure;
forming a second bonding insulation layer on an upper surface of a carrier wafer to form a carrier wafer structure;
bonding the donor wafer structure with the carrier wafer structure to form a bonding structure in which a back surface of the donor wafer faces upwardly;
grinding the back surface of the donor wafer;
cleaning a grinded surface of the bonding structure;
stripping the donor wafer remaining after the grinding by a spin cleaning process to expose the etch stopper layer;
removing the exposed etch stopper layer, in a plasma process chamber in which a recombination aid layer is coated, using a plasma cleaning gas including NF₃ to expose the semiconductor layer; and
treating a surface of the semiconductor layer to have a uniform thickness.

14. The method of claim 13, wherein the recombination aid layer includes at least one of Ni and AIN.

15. The method of claim 13,
wherein the plasma cleaning gas including NF₃ has a temperature of 30 to 35°C, and
wherein the NF₃-containing plasma cleaning gas comprises NF₃ gas: Ar gas: He gas mixed in a ratio of 1:100~400:150~600.

16. The method of claim 13, wherein grinding the back surface of the donor wafer comprises:
rough grinding 90 to 96% of a total thickness of the donor wafer at least once; and
finely grinding the roughly grinded donor wafer at least once to form a residual donor wafer with a thickness 15 to 20 µm thickness.

17. The method of claim 16, wherein finely grinding the donor wafer comprises grinding the bonding structure with the bonding structure positioned at an at an inclination,
wherein a thickness of an edge region of the residual donor wafer is thicker than a thickness of a central region of the residual donor wafer after the grinding.

18. The method of claim 13, wherein stripping the residual donor wafer comprises:
treating a surface of the residual donor wafer with a 1:100 diluted HF solution (HF:H₂O =1:100) to remove a native oxide layer on a surface of the bonding structure;
removing the residual donor wafer using a dilute NH₄OH solution (NH₄OH:H₂O = 1:20 to 40);
rinsing the surface of the bonding structure from which the etch stopper layer has been removed with H₂O; and
drying the surface of the bonding structure.

19. The method of claim 13, wherein treating the surface of the semiconductor layer comprises chemically treating dangling bonds of the surface of the semiconductor layer and materials agglomerated to the surface of the semiconductor layer.
